Europäisches Patentamt

European Patent Office

Office européen des brevets

(11) Veröffentlichungsnummer: **0 279 898 B1**

# EUROPÄISCHE PATENTSCHRIFT

(45) Veröffentlichungstag der Patentschrift: **14.08.91**

(51) Int. Cl.⁵: **C23C 16/26**

(21) Anmeldenummer: **87112638.9**

(22) Anmeldetag: **29.08.87**

(54) Verfahren zum Auftragen einer Verschleissschutzschicht und danach hergestelltes Ezeugnis.

(30) Priorität: **27.02.87 DE 3706340**

(43) Veröffentlichungstag der Anmeldung:
**31.08.88 Patentblatt 88/35**

(45) Bekanntmachung des Hinweises auf die
Patenterteilung:
**14.08.91 Patentblatt 91/33**

(84) Benannte Vertragsstaaten:
**CH DE ES FR GB IT LI SE**

(56) Entgegenhaltungen:
**EP-A- 0 157 212**
**EP-A- 0 166 708**
**WO-A-86/00093**
**DE-A- 3 335 132**

**PATENT ABSTRACTS OF JAPAN, unexamined applications, C Feld, Band 10, Nr. 214, 25 Juli 1986 THE PATENT OFFICE JAPANESE GOVERNMENT, Seite 38C 362**

**Taschenbuch der Werkstoffkunde (Stoffhütte), 4. Auflage, Seiten 1008-1013, Verlag von Wilhelm Ernst & Sohn, Berlin - München, BRD, 1967**

**Metals Handbook, Desk Edition, Seite 2.16,**

**American Society for Metals, Metals Park, Ohio, USA, 1985**

**Hartstoffe, Kieffer - Benesovsky, Seite 303, Springer-Verlag Wien, 1963**

(73) Patentinhaber: **Ernst Winter & Sohn (GmbH & Co.)**
**Osterstrasse 58**
**W-2000 Hamburg 19(DE)**

(72) Erfinder: **Meyer, Hans-Robert, Dr.**
**Eissendorfer Grenzweg 12**
**W-2100 Hamburg 90(DE)**
Erfinder: **Wiemann, Hans-Joachim, Dr.**
**Josthöhe 57**
**W-2000 Hamburg 63(DE)**

(74) Vertreter: **Minetti, Ralf, Dipl.-Ing.**
**Ballindamm 15**
**W-2000 Hamburg 1(DE)**

**Beschreibung**

Die Erfindung betrifft ein Verfahren zum Auftragen einer Verschleißschutzschicht in der Art eines Diamantfilmes auf einem Träger aus einem metallischen oder nichtmetallischen Hartstoff durch chemische Dampf- oder Plasmaabscheidung sowie nach diesem Verfahren hergestellte Verschleißschutzschichten.

Für den Einsatz in spanabhebenden Werkzeugen sind Schneideinsätze bekannt, die aus etallischen oder nichtmetallischen Hartstoffen bestehen. Dafür kommen insbesondere Hartmetalle aus einer Sinterlegierung in Betracht, wie Wolframkarbid und Kobalt oder Wolframkarbid mit Titankarbid und Kobalt. Weiterhin werden derartige Schneideinsätze hergestellt aus reinem Titankarbid oder beispielsweise aus Aluminiumoxid sowie Titannitrid oder Siliziumnitrid.

Soweit es sich also nicht um Reinmetalle handelt, kommen insbesondere Boride, Nitride oder Silizide von Metallen in Betracht, das heißt Werkstoffe, die einen möglichst hohen Elastizitätsmodul aufweisen.

Weiterhin ist es bekannt, Schneideinsätze aus einem weniger harten Werkstoff zur Erhöhung ihrer Lebensdauer durch Vergrößerung ihres Verschleißwiderstandes mit einer Beschichtung zu versehen, die beispielsweise aus Titannitrid oder Siliziumnitrid oder Aluminiumoxid oder enem anderen vorgenannten Werkstoff bestehen kann. Derartige Beschichtungen werden aufgetragen auf Trägern aus Hartmetallen, wie sie für die Zerspanung von Stahl, Nichteisenmetallen und anderen Werkstoffen Anwendung finden.

Der Auftrag solcher Verschleißschutzschichten kann nach bekannten Verfahren der chemischen Dampfabscheidung oder der chemischen Plasmaabscheidung oder durch ein reaktives Plasmasputtern erfolgen.

Beim Verfahren der chemischen Dampfabscheidung, das in der Fachwelt bezeichnet wird als CVD-Verfahren (Chemical Vapor Deposition) erfolgt die Herstellung dünner Schichten durch eine chemische Reaktion von gasförmigen Komponenten. Dieses Verfahren findet beispielsweise auch Anwendung bei der Herstellung von dünnen Siliziumschichten in der Halbleitertechnologie sowie für die Abscheidung von Pyrokohlenstoff mit extremer Härte und einer hohen anisotropischen Wärmeleitfähigkeit. Nach jüngeren Veröffentlichungen ist es auch möglich, unter Verwendung von Methangas zur Abscheidung von diamantartigem Kohlenstoff zu kommen, wobei unter hohen Unterdrücken jedoch Temperaturen in der Größenordnung von über 1.000 Grad Celsius gearbeitet wird.

Demgegenüber bildet das sogenannte Plasma-CVD-Verfahren den Unterschied, daß bei niedrigem Druck eine Aufheizung der Gasphase durch Hochfrequenz oder elektrische Entladung wie Glimmentladung erfolgt und die Gasteilchen entsprechend Ionen geladen sind und dadurch extrem energiereich sind, so daß sich metastabile Verbindungen bilden können, wie z. B. Diamant.

Bei dem dritten vorgenannten Verfahren des reaktiven Sputterns handelt es sich um ein Verfahren der Kathodenzerstäubung, bei dem eine feste Kathode durch Ionenbeschuß abgetragen wird und sich auf einem einige Zentimeter entfernten Substrat niederschlägt. Dabei kann auf dem Weg dahin der Gasphase, das heißt dem Plasma ein reaktives Gas wie Stickstoff oder Sauerstoff zugesetzt werden.

In der praktischen Anwendung dieser jungen technischen Entwicklungen ergeben sich jedoch Probleme, wenn es sich beispielsweise darum handelt, die Schneiden von spanabhebenden Werkzeugen, die mit einer Verschleißschutzschicht aus Diamant versehen sind, wirtschaftlich zu nutzen.

Neben unterschiedlichen Wärmeausdehnungskoeffizienten von Diamant und Metallen beruht das insbesondere auf dem Umstand, daß Diamant den sehr hohen Elastizitätsmodul von etwa $10,5 \times 10^{11}$ N/m² aufweist, während demgegenüber Hartmetalle lediglich einen Elastizitätsmodul von etwa 4 bis $5 \times 10^{11}$ N/m² haben. Dieser erhebliche Unterschied führt dazu, daß bei einer mechanischen Beanspruchung wie beim Bearbeiten von Metallen oder Nichteisenmetallen die auftretenden Kräfte zu einem vorzeitigen Zerbrechen der Diamantfilme auf ihren Unterlagen führen, die erheblich geringere E-Module haben, bzw. zu einem Aufsplittern des Diamantfilmes. In der industriellen Anwendung haben sich deshalb Verschleißschutzschichten aus Diamant, die nach den bekannten Verfahren auf den Trägerkörper aufgebracht wurden, insbesondere von spanabhebenden Werkzeugen wie Fräsern, Sägen und dergleichen, nicht durchsetzen können.

Nach der EP-A2-0 166 708 ist es bekannt, auf einem Träger aus Metall durch chemische Dampfabscheidung dünne Schichten aus Diamant aufzutragen. Hierbei handelt es sich um Diamantschichten von einer hohen Diamantkonzentration, die sich voneinander nicht unterscheiden. Als Verschleißschutzschicht für ein Werkzeug ist ein derartiger Diamantbelag jedoch nicht sehr geeignet, wenn das Werkzeug hohen Beanspruchungen ausgesetzt wird. Das ist darauf zurückzuführen, daß Metalle einerseits und Diamant andererseits erhebliche Unterschiede in der Wärmedehnung aufweisen sowie in der Elastizität bzw. in der Größe ihres Elastizitätsmoduls. Eine hohe mechanische Beanspruchung eines Metallwerkzeuges mit einer Diamantbeschichtung der bekannten Art führt deshalb insbesondere infolge der Erwärmung zu einem Absplittern des Diamantbelages.

Aufgabe der Erfindung ist es, ein Verfahren zum Auftragen einer Verschleißschutzschicht mit einem Diamantfilm auf einem Träger zu schaffen, bei welchem den unterschiedlichen Elastizitätsmodulen insoweit Rechnung getragen wird, daß sich ihre Größendifferenz nicht nachteilig auswirkt auf die Beanspruchung des Diamantfilmes, so daß dieser stärker beansprucht werden kann, als es bisher möglich war.

Nach der Erfindung ist dafür vorgesehen, daß auf einem Träger wie z. B. einem metallischen Schneideinsatz eines spanabhebenden Werkzeuges aufeinanderfolgend Schichten aufgetragen werden, die jeweils einen höheren Diamantanteil und einen höheren Elastizitätsmodul als die darunterliegende Schicht aufweisen, wobei die äußerste Schicht eine Schicht aus Diamant ist. Dadurch ergibt sich eine geringere Größendifferenz zwischen dem Elastizitätsmodul des außenliegenden Diamantfilmes und dem vom Werkstoff des Trägers, so daß die Gefahr einer Zerstörung des Diamantfilmes vermieden wird.

Um die Verschleißschutzschicht so aufzubauen, daß stufenweise vom Träger ausgehend bis zum außenliegenden Diamantfilm Zwischenlagen von unterschiedlichen, steigenden Elastizitätsmodulen vorhanden sind, deren Größe möglichst nahe an den Modul von Diamant heranreicht, ist es am zweckmäßigsten, die einzelnen Schichten mit fortlaufend ansteigenden Diamantanteilen zu versehen, so daß z. B. eine unten auf dem Träger liegende Schicht nur einen Diamantanteil von beispielsweise 10 % Gewichtsanteile hätte, die darüber liegende Schicht einen Anteil von 20 %, die fünfte Schicht 50 % und so fort, wobei als Verbundwerkstoff beispielsweise Nickel oder Kobalt aber auch Graphit Anwendung finden könnte und zwar mit abfallenden Gewichtsprozentanteilen, das heißt also in der untersten Schicht von 90 % und in der fünften Schicht von 50 %. Dieses Vorgehen würde den gleichzeitigen Niederschlag des Verbundwerkstoffes zusammen mit Diamant bei der Herstellung der Schichtten voraussetzen, was nach dem gegenwärtigen Erkenntnisstand technisch noch problematisch ist.

Die Erfindung sieht deshalb in einer Ausgestaltung vor, auf dem Träger fortlaufend Schichten aufzudampfen, die sich im einzelnen dadurch unterscheiden, daß eine nachfolgend aufgetragene Schicht aus einem Material besteht, dessen Elastizitätsmodul größer ist als derjenige des Materials der darunterliegenden Schicht, wobei dann als letzte vorzugsweise erheblich stärkere Schicht eine Diamantschicht aufgetragen wird. Dabei ist allgemein unter Diamantschicht zu verstehen, daß es sich um eine Schicht aus diamantartigen Kohlenstoff handelt.

Die einzelnen unterhalb der außenliegenden Diamantschicht befindlichen Schichten können eine Dicke haben von etwa 1 bis 20 $\mu$m, während die außenliegende Diamantschicht wesentlich dicker ausgebildet sein kann und zwar beispielsweise in der Größenordnung von 10 bis 500 $\mu$m.

Von besonderem Vorteil ist es, daß sich das Verfahren auf einem breiten Anwendungsgebiet ausnutzen läßt, da seine Anwendung nicht beschränkt ist auf bestimmte Abmessungen beispielsweise von Schneideinsätzen für spanabhebende Werkzeuge. Das erfindungsgemäße Verfahren erlaubt es nämlich, stufenweise aufgetragene Schichten bzw. die gesamte Verschleißschutzschicht auf komplizierteren Formen wie beispielsweise Profilen mit kleiner Verzahnung aufzubringen. Dabei kann es sich also beispielsweise auch handeln um verzahnte Formwerkzeuge aber auch beispielsweise um gezahnte Abrichtrollen zum Formabrichten von Schleifscheiben. Stattdessen kann die Standfestigkeit anderer Werkzeuge durch den Auftrag der erfindungsgemäßen Verschleißschutzschicht wesentlich verbessert werden wie beispielsweise von Messern und anderen Gegenständen, die auch nichtmetallisch sind und beispielsweise aus Glas bestehen wie Linsen und dergleichen.

Ausführungsbeispiele der Erfindung sind nachstehend unter Bezugnahme auf eine Zeichnung erläutert. Darin zeigen:

Figur 1: einen Fräser in der Seitenansicht;
Figur 2: den Schneideinsatz eines Fräsers in der Draufsicht;
Figur 3: eine Verschleißschutzschicht im Querschnitt und

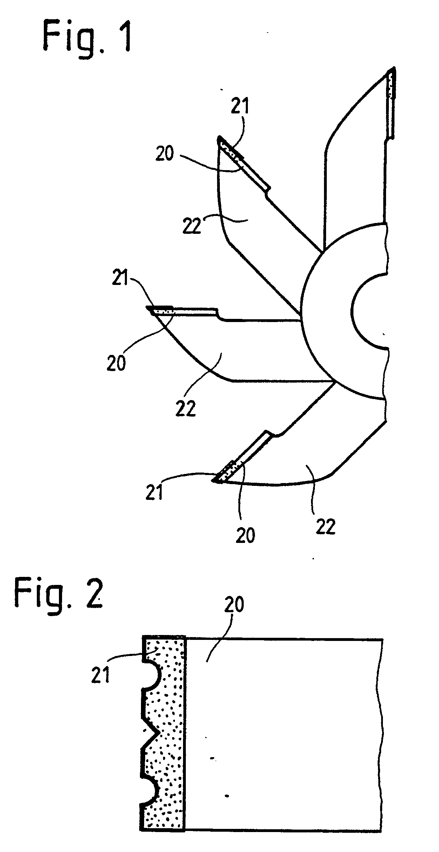

Der in Figur 1 wiedergegebene Fräser besitzt mehrere Zähne 22, die jeweils einen Schneideinsatz 20 tragen, dessen Schneidkantenbereich mit einer Verschleißschutzschicht 21 versehen ist, die außen einen Diamantfilm trägt.

Entsprechend Figur 2 ist der Außenrandbereich des Schneideinsatzes mit einer Profilierung versehen, wobei die Anordnung derart getroffen ist, daß auch die Profilflächen von der durch Plasmaabscheidung aufgetragenen Verschleißschutzschicht bedeckt sind.

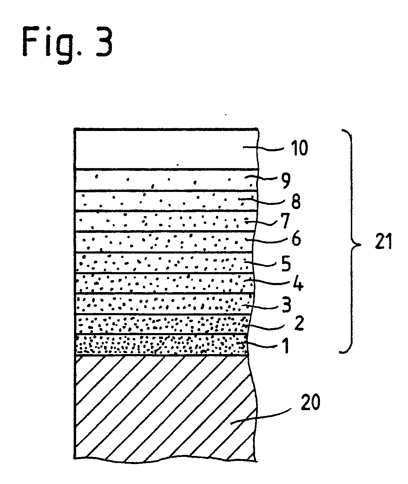

Eine Verschleißschutzschicht nach Figur 3 besteht aus zehn Schichten 1 bis 10, die aufeinanderfolgend auf dem Träger 3 aufgedampft sind. Diese Schichten 1 bis 10 unterscheiden sich durch unterschiedliche Härten und zwar dahingehend, daß die jeweils über einer anderen Schicht liegende Schicht einen höheren Elastizitätsmodul aufweist, als die darunterliegende Schicht. Bei diesem Ausführungsbeispiel ist dafür vorgesehen, daß die Schicht 1 10 % Gewichtsanteile an Diamant enthält und 90 % Kobalt, während die Schicht 2 einen Gewichtsdiamantanteil von 20 % und einen Metallanteil von 80 % aufweist. Diese stufenförmige Verteilung ergibt sich auch über die anderen Schicht hinweg, so daß als außenliegende Schicht 10 eine solche vorhanden ist, die allein aus diamantartigen Kohlenstoff besteht.

Wenn bei diesem Beispiel Kobalt als Verbundwerkstoff vorgesehen ist, so wird berücksichtigt, daß beim Niederschlagen eines Metalles zusammen mit Diamant in der Dampfphase der in Metall eindringende Diamant die Ausbildung von Karbid auslöst, so daß die Verwendung von Metallkarbiden zusammen mit Diamant innerhalb einer Schicht weniger geeignet ist, als die Verwendung von Reinmetallen, die keine Karbide bilden wie insbesondere von Nickel oder Kobalt.

**Patentansprüche**

1. Verfahren zum Auftragen einer Verschleißschutzschicht in der Art eines Diamantfilmes auf einen Träger (20) aus einem metallischen oder nichtmetallischen Hartstoff durch chemische Dampf- oder Plasmaabscheidung, dadurch gekennzeichnet, daß auf dem Träger (20) aufeinanderfolgend Schichten (1-10) aufgetragen werden, die jeweils einen höheren Diamantanteil und einen höheren Elastizitätsmodul als die darunter liegende Schicht aufweisen, wobei die äußerste Schicht (10) eine Schicht aus Diamant ist.

2. Verfahren nach Anspruch 1, dadurch gekennzeichnet, daß die äußere Diamantschicht (10) in größerer Schichtdicke als die darunter liegenden Schichten (1-9) aufgetragen wird.

3. Verfahren nach Anspruch 1, dadurch gekennzeichnet, daß auf dem Träger (20) als erste Schicht (1) ein Werkstoff, der einen höheren Elastizitätsmodul als der Träger (20) aufweist, zusammen mit Diamant aufgetragen wird.

4. Verschleißschutzschicht für metallische und nichtmetallische Träger, dadurch gekennzeichnet, daß die Verschleißschutzschicht (21) aus mehreren durch chemische Dampf- oder Plasmaabscheidung aufgetragenen übereinander liegenden Schichten (1-10) aus einem Werkstoff und Diamant besteht, die fortlaufend von von unten nach außen einen höheren Diamantanteil und größeren Elastizitätsmodul aufweisen, wobei die äußerste Schicht (10) eine Schicht aus Diamant ist.

5. Verschleißschutzschicht nach Anspruch 4, dadurch gekennzeichnet, daß die äußere Schicht (10) aus Diamant dicker ausgebildet ist als die darunter-liegenden Schichten (1-9).

6. Verschleißschutzschicht nach Anspruch 4, dadurch gekennzeichnet, daß die äußerste Diamantschicht (10) eine Dicke von 5 bis 500 μm aufweist und die darunterliegenden Schichten Dicken von 2 bis 50 μm.

7. Verschleißschutzschicht nach Anspruch 4, dadurch gekennzeichnet, daß als Werkstoff für die Bindung Von Diamanten Boride, Nitride, Silizide oder Karbide von Metallen vorgesehen sind.

8. Verschleißschutzschicht nach Anspruch 4, dadurch gekennzeichnet, daß der Werkstoff ein Reinmetall ist.

9. Verschleißschutzschicht nach Anspruch 4, dadurch gekennzeichnet, daß der Träger (20) der Verschleißschutzschicht als Schneideinsatz eines spanabhebenden werkzeuges (22) ausgebildet ist.

10. Verschleißschutzschicht nach Anspruch 4, dadurch gekennzeichnet, daß der Träger (20) der Verschleißschutzschicht (21) eine Formabrichtrolle ist.

11. Verschleißschutzschicht nach Anspruch 4, dadurch gekennzeichnet, daß der Träger (20) der Verschleißschutzschicht (21) als ein Messer ausgebildet ist.

12. Verschleißschutzschicht nach Anspruch 8, dadurch gekennzeichnet, daß der Werkstoff Nikkel oder Kobalt ist.

**Claims**

1. Process for applying a protection layer againt wear and tear of the type of a diamond film onto a support (20) made of a metallic or non metallic hard substance by chemical damp or plasma separation, characterized in that successively layers (1-10) are applied onto the support (20) which have respectively a higher diamond ratio and a higher modulus of elasticity than the subjacent layer, the most exterior layer (10) being a layer made of diamond.

2. Process according to claim 1, characterized in that the exterior diamond layer (10) is applied in a higher thickness than the subjacent layers (1-9).

3. Process according to claim 1, characterized in that a material having a higher modulus of elasticity than the support (20) is applied together with diamond onto the support (20) as first layer (1).

4. Protection layer against wear and tear for metallic and non metallic supports, characterized in that the protection layer against wear and tear (21) consists of several superposed layers (1-10) made of a material and diamond applied by chemical damp or plasma separation which have continuously from below to the external side a higher diamond ratio and a higher modulus of elasticity, the most exterior layer (10) being a layer of diamond.

5. Protection layer against wear and tear according to claim 4, characterized in that the exterior layer (10) of diamond is thicker than the subjacent layers (1-9).

6. Protection layer against wear and tear according to claim 4, characterized in that the most exterior diamond layer (10) has a thickness of 5 to 500 $\mu$m and the subjacent layers a thickness of 2 to 50 $\mu$m.

7. Protection layer against wear and tear according to claim 4, characterized in that borides, nitrides, silicides or metal carbids are provided as material for the binding of diamonds.

8. Protection layer against wear and tear according to claim 4, characterized in that the material is a pure metal.

9. Protection layer against wear and tear according to claim 4, characterized in that the support (20) of the protection layer against wear and tear is constituted as a cutting insert of a cutting tool (22).

10. Protection layer against wear and tear according to claim 4, characterized in that the support (20) of the protection layer against wear and tear is a form dressing roller.

11. Protection layer against wear and tear according to claim 4, characterized in that the support (20) of the protection layer against wear and tear (21) is constituted as a knife.

12. Protection layer against wear and tear according to claim 8, characterized in that the material is nickel or cobalt.

**Revendications**

1. Procédé pour appliquer une couche protectrice contre l'usure du type pellicule diamantée sur un support (20) en une substance dure métallique ou non métallique par séparation chimique de vapeur ou de plasma, caractérisé en ce que des couches (1-10) sont appliquées l'une après l'autre sur le support (20), couches qui présentent respectivement un taux en diamant plus élevé et un module d'élasticité plus élevé que la couche sous-jacente, la couche la plus à l'extérieur (10) étant une couche en diamant.

2. Procédé selon la revendication 1, caractérisé en ce que la couche extérieure en diamant (10) est appliquée en une épaisseur plus importante que les couches situées en dessous de celle-ci (1-9).

3. Procédé selon la revendication 1, caractérisé en ce qu'une matière qui présente un module d'élasticité plus important que le support (20) est appliquée avec du diamant sur le support (20) comme première couche (1).

4. Couche protectrice contre l'usure pour supports métalliques ou non métalliques, caractérisée en ce que la couche protectrice contre l'usure (21) est constituée par plusieurs couches (1-10) superposées d'une matière et de diamant appliquées par séparation chimique de vapeur ou de plasma, couches qui présentent continuellement du bas vers l'extérieur un taux de diamant croissant et un module d'élasticité plus important, la couche la plus à l'extérieur (10) étant une couche en diamant.

5. Couche protectrice contre l'usure selon la revendication 4, caractérisée en ce que la couche extérieure (10) en diamant est configurée plus épaisse que les couches situées en dessous (1-9).

6. Couche protectrice contre l'usure selon la revendication 4, caractérisée en ce que la couche de diamant la plus à l'extérieur (10) présente une épaisseur de 5 à 500 $\mu$m et que les couches situées en dessous ont des épaisseurs de 2 à 50 $\mu$m.

7. Couche protectrice contre l'usure selon la revendication 4, caractérisée en ce que des borures, nitrures, siliciures ou carbures de métaux sont prévus comme matériaux pour la liaison de diamants.

8. Couche protectrice contre l'usure selon la revendication 4, caractérisée en ce que le matériau est un métal pur.

9. Couche protectrice contre l'usure selon la revendication 4, caractérisée en ce que le support (20) de la couche protectrice contre l'usure est configurée comme un insert tranchant d'un outil d'usinage (22).

10. Couche protectrice conte l'usure selon la revendication 4, caractérisée en ce que le support (20) de la couche protectrice contre l'usure (21) est un galet de dressage de moule.

11. Couche protectrice contre l'usure selon la revendication 4, caractérisée en ce que le support (20) de la couche protectrice contre l'usure (21) est configuré comme un couteau.

12. Couche protectrice contre l'usure selon la revendication 8, caractérisée en ce que le matériau est du nickel ou du cobalt.

# Fig. 1

# Fig. 2

# Fig. 3